# EUROPÄISCHE PATENTANMELDUNG

(11) **EP 1 887 621 A2**
(43) Veröffentlichungstag der Anmeldung: **13.02.2008**
(21) Anmeldenummer: 07015429.9
(22) Anmeldetag: 07.08.2007
(51) Int. Cl.: H01L 23/40

(54) **Leistungselektronik mit Kühlkörper**

(30) Priorität: 12.08.2006 DE 102006037825; 22.12.2006 DE 102006061215
(71) Anmelder: Diehl AKO Stiftung & Co. KG, 88239 Wangen (DE)
(72) Erfinder: Müller, Alexander, 88339 Bad Waldsee - Reute (DE); Rapp, Harald, 88239 Wangen im Allgäu (DE)
(74) Vertreter: Diehl Patentabteilung

(57) **Zusammenfassung**

Es wird eine Leistungselektronik mit einer Leiterplatte (2), auf der wenigstens ein zu kühlendes Bauteil (3, 4) montiert ist, und einem Kühlkörper (1), der auf der dem zu kühlenden Bauteil (3, 4) zugewandten Seite der Leiterplatte (2) in wärmeleitendem Kontakt zu dem zu kühlenden Bauteil (3, 4) angeordnet ist, vorgeschlagen. Um eine einfache Herstellung und Montage der Leistungselektronik zu erreichen, weist diese ferner eine Positionierungseinrichtung (8, 9, 10) zum Positionieren der Leiterplatte (2) in einer definierten Lagebeziehung relativ zum Kühlkörper (1), in welcher der Abstand zwischen dem Kühlkörper (1) und der Leiterplatte (2) etwa der Bauhöhe des wenigstens einen zu kühlenden Bauteils (3, 4) entspricht, und wenigstens ein Befestigungselement (5, 6, 7) zum Befestigen der Leiterplatte (2) am Kühlkörper (1) und gleichzeitig Pressen des wenigstens einen zu kühlenden Bauteils (3, 4) gegen den Kühlkörper (1) auf.

## Beschreibung

Die vorliegende Erfindung betrifft eine Leistungselektronik, insbesondere eine Leistungselektronik mit einem Kühlkörper, wie sie beispielsweise für Waschmaschinenantriebe Verwendung findet.

Leistungselektroniken enthalten Halbleiterbauelemente, so genannte Leistungsbausteine, die im Betrieb gekühlt werden müssen. Diese Aufgabe übernehmen im Allgemeinen Kühlkörper aus Metall, die mittels geeigneter Befestigungsmittel direkt gegen die zu kühlenden Bauteile gepresst werden, sodass ein guter Wärmeübergang gewährleistet ist. Die Leistungsbausteine sind auf einer Leiterplatte montiert, die ebenfalls mittels geeigneter Befestigungsmittel mit dem Kühlkörper verbunden ist.

Aus der EP 0 632 686 A1 ist es zum Beispiel bekannt, jeden Leistungsbaustein auf einer Leiterplatte mit einem eigenen Kühlkörper zu versehen, der mittels eines Rahmens, der das zu kühlende Bauteil umgibt und der auf der Leiterplatte montiert wird, über an dem Rahmen angeformte Federzungen gegen die Oberseite des Bauteils gedrückt wird.

Ferner beschreibt die DE 199 46 354 A1 die Montage einer Leiterplatte und eines Strangpress-Kühlkörpers auf einem gemeinsamen stabilen Grundträger, welche Einheit dann in einem Gehäuse in ein Chassis eingebaut werden kann.

Die EP 0 483 058 A1 offenbart einen speziellen Kühlkörper mit Hohlprofil-Kühlrippen aus stranggepresstem Aluminium, der ein erhöhtes Rippenverhältnis aufweist.

Die beiden letztgenannten Dokumente enthalten keine näheren Angaben zur thermischen Kopplung von zu kühlenden Bauteilen auf der Leiterplatte an den Kühlkörper.

Die Form des Kühlkörpers und die Verbindung von Leiterplatte und Leistungsbausteinen mit dem Kühlkörper verursachen einen großen Teil der Kosten bei der Fertigung und Montage einer Leistungselektronik. Es besteht deshalb Bedarf an einer geschickten Konstruktion von Kühlkörper und elektronischen Komponenten zur Minimierung der Fertigungskosten einer Leistungselektronik.

Der vorliegenden Erfindung liegt deshalb die Aufgabe zugrunde, eine Leistungselektronik mit einem Kühlkörper vorzusehen, der einfach herzustellen und zu montieren ist. Zweckmäßigerweise soll die Leistungselektronik sowohl für eine einfache Handmontage als auch für eine Automatisierung geeignet sein.

Diese Aufgabe wird gelöst durch eine Leistungselektronik mit den Merkmalen des Anspruchs 1. Vorteilhafte Ausgestaltungen und Weiterbildungen der Erfindung sind Gegenstand der abhängigen Ansprüche.

Die Leistungselektronik weist eine Leiterplatte, auf der wenigstens ein zu kühlendes Bauteil montiert ist, und einen Kühlkörper, der auf der dem zu kühlenden Bauteil zugewandten Seite der Leiterplatte in wärmeleitendem Kontakt zu dem zu kühlenden Bauteil angeordnet ist, auf und ist weiter gekennzeichnet durch eine Positionierungseinrichtung zum Positionieren der Leiterplatte in einer definierten Lagebeziehung relativ zum Kühlkörper, in welcher der Abstand zwischen dem Kühlkörper und der Leiterplatte etwa der Bauhöhe des wenigstens einen zu kühlenden Bauteils entspricht; und wenigstens ein Befestigungselement zum Befestigen der Leiterplatte am Kühlkörper und gleichzeitig Pressen des wenigstens einen zu kühlenden Bauteils gegen den Kühlkörper.

Durch die Positionierungseinrichtung können die Leiterplatte mit den zu kühlenden Bauteilen und der Kühlkörper in ihrer gewünschten Lagebeziehung zueinander vormontiert werden. Anschließend können in einem Arbeitsgang durch die Befestigungselemente sowohl die Leiterplatte am Kühlkörper befestigt als auch die zu kühlenden Bauteile auf der Leiterplatte mit dem Kühlkörper in guten thermischen Kontakt gebracht werden. Mit dieser Konstruktion ist zur Montage der Leiterplatte und der zu kühlenden Bauteile am Kühlkörper nur eine geringe Anzahl an Komponenten und Fertigungsschritten erforderlich, sodass die Fertigung und der Zusammenbau der Leistungselektronik vereinfacht und die Herstellungskosten insgesamt gesenkt werden können.

In einer Ausgestaltung der Erfindung weist die Positionierungseinrichtung eine in einem Wandabschnitt des Kühlkörpers vorgesehene Nut, in welche die Leiterplatte einschiebbar ist und welche einen vordefinierten Abstand zur Kühlkörperfläche besitzt, und einen an der Leiterplatte vorgesehenen Anschlag zum Definieren der (maximalen) Einschubtiefe der Leiterplatte in die Nut auf. Unter Verwendung dieser Positionierungseinrichtung können die Komponenten auf einfache Weise genau in der gewünschten Lagebeziehung zueinander (vor)montiert werden.

In einer weiteren Ausgestaltung der Erfindung ist das wenigstens eine Befestigungselement eine selbstschneidende Schraube, und der Kühlkörper weist auf seiner der Leiterplatte zugewandten Seite wenigstens einen Schlitz auf, in den die selbstschneidende Schraube eindrehbar ist.

Vorzugsweise presst wenigstens ein Befestigungselement ein zu kühlendes Bauteil über die Leiterplatte gegen den Kühlkörper, sodass gleichzeitig die Leiterplatte am Kühlkörper befestigt wird. In diesem Fall kann wenigstens ein weiteres Befestigungselement ein weiteres zu kühlendes Bauteil direkt gegen den Kühlkörper pressen.

In der bevorzugten Ausführungsform der Erfindung weist der Kühlkörper auf seiner der Leiterplatte abgewandten Seite eine Vielzahl von Kühlrippen auf.

In einer besonders bevorzugten Ausführungsform ist der Kühlkörper ein einfach herzustellendes Strangpressteil, bei dem die Kühlrippen, die Schlitze, der Wandabschnitt und die Nut parallel zueinander verlaufen.

In einer noch weiteren Ausgestaltung der Erfindung sind die Leiterplatte und ihre Bauteile wenigstens teilweise lackiert oder vergossen.

Die Leistungselektronik der Erfindung ist in vorteilhafter Weise als eine Leistungselektronik für einen Waschmaschinenantrieb einsetzbar.

Obige sowie weitere Merkmale und Vorteile der Erfindung werden aus der nachfolgenden Beschreibung eines bevorzugten, nicht-einschränkenden Ausführungsbeispiels unter Bezugnahme auf die beiliegenden Zeichnungen besser verständlich. Darin zeigen:

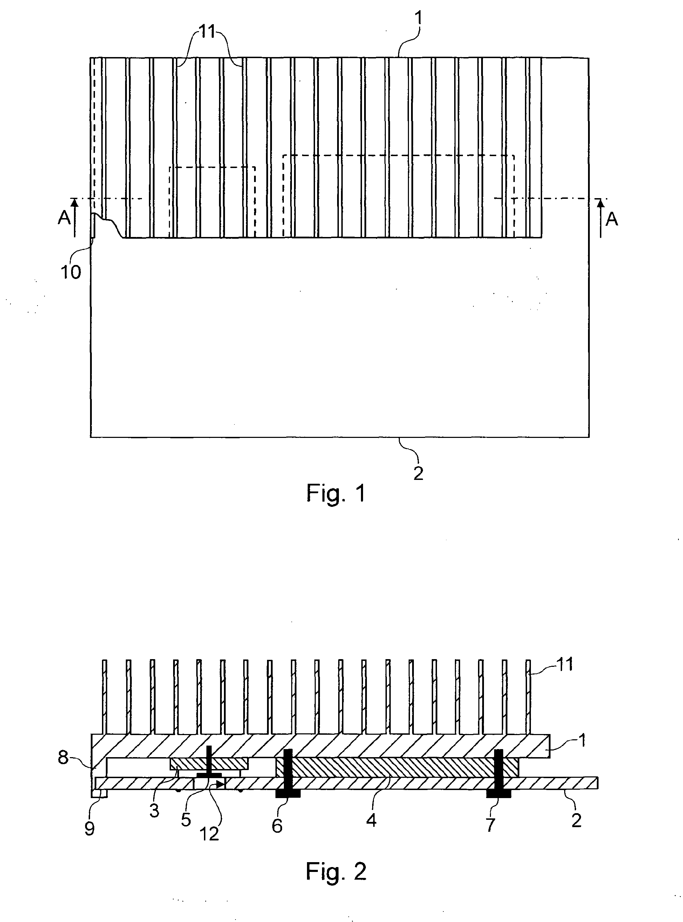

- Fig. 1: eine schematische Draufsicht einer Leistungselektronik gemäß einem Ausführungsbeispiel; und
- Fig. 2: eine Schnittansicht der Leistungselektronik von Fig. 1 entlang Linie A-A in Fig. 1.

Die vorliegende Erfindung wird nachfolgend anhand einer Drehzahlelektronik eines Waschmaschinenantriebs beschrieben; die Erfindung ist aber selbstverständlich analog auch auf andere Leistungselektroniken anwendbar, ohne auf dieses spezielle Ausführungsbeispiel beschränkt zu sein.

Der Kühlkörper 1 ist ein Strangpressteil zum Beispiel aus Aluminium oder einem anderen Metall mit guten Wärmeleitungseigenschaften. Der Kühlkörper 1 besteht aus einem plattenförmigen Grundkörper, von dem in einem Seitenbereich des Grundkörpers ein Wandabschnitt 8 vorsteht. In diesem Wandabschnitt 8 ist eine Nut 9 ausgebildet. Ferner ist eine Vielzahl von Kühlrippen 11 auf der dem Wandabschnitt 8 abgewandten Seite des Kühlkörpers 1 vorgesehen, um die Kühlleistung des Kühlkörpers 1 in bekannter Weise zu erhöhen. Weiter sind auf der den Kühlrippen 11 abgewandten Seite des Kühlkörpers 1 mehrere Schlitze (nicht dargestellt) ausgebildet.

Der Wandabschnitt 8, die Nut 9, die Kühlrippen 11 und die Schlitze sind alle parallel zueinander ausgebildet, sodass der gesamte Kühlkörper in einfacher Weise durch ein Strangpresswerkzeug als ein Strangpressteil gefertigt werden kann. Das Strangpressteil muss nicht nachbearbeitet oder nachbehandelt werden, es muss lediglich auf die gewünschte Länge geschnitten werden.

Auf der den Kühlrippen 11 abgewandten Seite des Kühlkörpers 1 wird eine Leiterplatte 2 montiert. Auf dieser Leiterplatte 2 sind mehrere zu kühlende Bauteile 3, 4, so genannte Leistungsbausteine, sowie weitere Bauteile montiert, wobei zumindest die Leistungsbausteine 3, 4 auf der dem Kühlkörper 1 zugewandten Seite der Leiterplatte 2 montiert sind. Im vorliegenden Ausführungsbeispiel ist der eine Leistungsbaustein 3 zum Beispiel ein Brückengleichrichter, und der andere Leistungsbaustein 4 enthält zum Beispiel zum Beispiel drei Halbbrücken und die zugehörige Ansteuerschaltung.

Die Leiterplatte 2 wird in die Nut 9 im Wandabschnitt 8 des Kühlkörpers eingeschoben und damit am Kühlkörper 1 vormontiert. Der Abstand der Nut 9 von der Kühlkörperoberfläche definiert dabei den gewünschten Abstand zwischen der Leiterplatte 2 und dem Kühlkörper 1, der etwa der Bauhöhe der zu kühlenden Bauteile 3, 4 entspricht. Des Weiteren ist die Leiterplatte 2 mit einem Anschlag 10 versehen, der die maximale Einschubtiefe der Leiterplatte 2 in die Nut 9 festlegt, sodass die Leiterplatte 2 auch diesbezüglich in einer vordefinierten Lagebeziehung relativ zum Kühlkörper 1 vormontiert werden kann.

Das eine zu kühlende Bauteil 3 ist mittels einer selbstschneidenden Schraube 5 als Befestigungselement der Erfindung, die in einen entsprechenden Schlitz (nicht dargestellt) im Kühlkörper 1 eingedreht wird, zur Herstellung eines guten thermischen Kontakts direkt gegen den Kühlkörper 1 gepresst. Zu diesem Zweck ist in der Leiterplatte 2 eine Durchbrechung 12 vorgesehen.

Für das andere zu kühlende Bauteil 4 sind zwei weitere selbstschneidende Schrauben 6, 7 als Befestigungselemente der Erfindung vorgesehen. Im Gegensatz zum obigen Bauteil 3 wird dieses Bauteil 4 aber mittels der Schrauben 6, 7 über die Leiterplatte 2 gegen den Kühlkörper 1 gepresst. Hierdurch wird einerseits ein guter thermischer Kontakt zwischen dem zu kühlenden Bauteil 4 und dem Kühlkörper 1 gewährleistet, und gleichzeitig wird die Leiterplatte 2 an dem Kühlkörper 1 befestigt.

Als bevorzugte Befestigungselemente 5-7 sind hier selbstschneidende Schrauben genannt. Die Erfindung ist aber nicht nur hierauf beschränkt; es können auch andere Befestigungselemente wie einfache Schrauben, Bolzen, Nieten und dergleichen verwendet werden.

Durch die vordefinierte Lage der Leiterplatte 2 in der Nut 9 des Kühlkörpers 1 treffen die selbstschneidenden Schrauben 5, 6, 7 immer automatisch in die Schlitze in der Unterseite des Kühlkörpers 1. Ein Suchen nach entsprechenden Befestigungslöchern im Kühlkörper 1 entfällt. Die zu kühlenden Bauteile 3, 4 werden mittels der Befestigungselemente 5-7 über die Leiterplatte 2 gegen den Kühlkörper 1 gepresst; eine zusätzliche Befestigung der Leiterplatte 2 am Kühlkörper 1 entfällt.

Die Herstellung des Kühlkörpers 1 ist als Strangpressteil einfach, und der einfache Zusammenbau von Leiterplatte 2 und Kühlkörper 1 ist sowohl für die Handmontage als auch für die automatisierte Montage geeignet.

## Patentansprüche

1. Leistungselektronik, mit
einer Leiterplatte (2), auf der wenigstens ein zu kühlendes Bauteil (3, 4) montiert ist; und
einem Kühlkörper (1), der auf der dem zu kühlenden Bauteil (3, 4) zugewandten Seite der Leiterplatte (2) in wärmeleitendem Kontakt zu dem zu kühlenden Bauteil (3, 4) angeordnet ist,
**gekennzeichnet durch**
eine Positionierungseinrichtung (8, 9, 10) zum Positionieren der Leiterplatte (2) in einer definierten Lagebeziehung relativ zum Kühlkörper (1), in welcher der Abstand zwischen dem Kühlkörper (1) und der Leiterplatte (2) etwa der Bauhöhe des wenigstens einen zu kühlenden Bauteils (3, 4) entspricht; und
wenigstens ein Befestigungselement (5, 6, 7) zum Befestigen der Leiterplatte (2) am Kühlkörper (1) und gleichzeitig Pressen des wenigstens einen zu kühlenden Bauteils (3, 4) gegen den Kühlkörper (1).

2. Leistungselektronik nach Anspruch 1,
**dadurch gekennzeichnet,**
**dass** die Positionierungseinrichtung (8, 9, 10) eine in einem Wandabschnitt (8) des Kühlkörpers (1) vorgesehene Nut (9) aufweist, in welche die Leiterplatte (2) einschiebbar ist und welche einen vordefinierten Abstand zur Kühlkörperfläche besitzt.

3. Leistungselektronik nach Anspruch 2,
**dadurch gekennzeichnet,**
**dass** die Positionierungseinrichtung (8, 9, 10) einen an der Leiterplatte (2) vorgesehenen Anschlag (10) zum Definieren der Einschubtiefe der Leiterplatte (2) in die Nut (9) aufweist.

4. Leistungselektronik nach einem der Ansprüche 1 bis 3,
**dadurch gekennzeichnet,**
**dass** das wenigstens eine Befestigungselement (5, 6, 7) eine selbstschneidende Schraube ist.

5. Leistungselektronik nach Anspruch 4,
**dadurch gekennzeichnet,**
**dass** der Kühlkörper (1) auf seiner der Leiterplatte (2) zugewandten Seite wenigstens einen Schlitz aufweist, in den die selbstschneidenden Schrauben (5, 6, 7) eindrehbar sind.

6. Leistungselektronik nach einem der Ansprüche 1 bis 5,
**dadurch gekennzeichnet,**
**dass** wenigstens ein Befestigungselement (6, 7) wenigstens ein zu kühlendes Bauteil (4) über die Leiterplatte (2) gegen den Kühlkörper (1) presst.

7. Leistungselektronik nach Anspruch 6,
**dadurch gekennzeichnet,**
**dass** wenigstens ein weiteres Befestigungselement (5) wenigstens ein weiteres zu kühlendes Bauteil (3) direkt gegen den Kühlkörper (1) presst.

8. Leistungselektronik nach einem der Ansprüche 1 bis 7,
**dadurch gekennzeichnet,**
**dass** der Kühlkörper (1) auf seiner der Leiterplatte (2) abgewandten Seite eine Vielzahl von Kühlrippen (11) aufweist.

9. Leistungselektronik nach einem der Ansprüche 1 bis 8,
**dadurch gekennzeichnet,**
**dass** der Kühlkörper (1) ein Strangpressteil ist, bei dem die Kühlrippen (11), die Schlitze, der Wandabschnitt (8) und die Nut (9) parallel zueinander verlaufen.

10. Leistungselektronik nach einem der Ansprüche 1 bis 9,
**dadurch gekennzeichnet,**
**dass** die Leiterplatte (2) und ihre Bauteile wenigstens teilweise lackiert oder vergossen sind.

11. Leistungselektronik nach einem der Ansprüche 1 bis 10,
**dadurch gekennzeichnet,**
**dass** die Leistungselektronik eine Leistungselektronik für einen Waschmaschinenantrieb ist.
